Europäisches Patentamt

European Patent Office

Office européen des brevets

(11) Publication number: **0 128 986 B1**

# EUROPEAN PATENT SPECIFICATION

(45) Date of publication of patent specification: **27.02.91**  (51) Int. Cl.⁵: **H01L 21/66, H01L 23/66**

(21) Application number: **83307735.7**

(22) Date of filing: **20.12.83**

(54) Monolithic microwave integrated circuit and method for selecting it.

(30) Priority: **23.12.82 JP 231306/82**
**02.02.83 JP 16781/83**

(43) Date of publication of application:
**27.12.84 Bulletin 84/52**

(45) Publication of the grant of the patent:
**27.02.91 Bulletin 91/09**

(84) Designated Contracting States:
**DE FR GB NL SE**

(56) References cited:
**WO-A-82/02603**
**US-A- 3 922 707**

(73) Proprietor: **SUMITOMO ELECTRIC INDUSTRIES LIMITED**
**No. 15, Kitahama 5-chome, Higashi-ku**
**Osaka-shi, Osaka 541(JP)**

(72) Inventor: **Suzuki, Tomihiro c/o Osaka Works of Sumitomo**
**Electric Ind., Ltd. 1-3, Shimaya 1-chome**
**Konohana-ku Osaka(JP)**

(74) Representative: **Rackham, Stephen Neil et al**
**GILL JENNINGS & EVERY 53-64 Chancery Lane**
**London WC2A 1HN(GB)**

Description

The present invention relates to a monolithic microwave integrated circuit which can be produced without a sacrifice in its frequency characteristics and circuits having the required characteristics can be selected easily.

A monolithic microwave integrated circuit is produced by assembling MESFET's, metal Schottky barrier semiconductor field effect transistors, Schottky diodes, inductances and capacitances on the surface of a semiconductor substrate of, for example, GaAs. Therefore, as compared with a MIC (microwave integrated circuit) the monolithic microwave integrated circuit has advantages that it requires smaller numbers of bonding pads and bonds and less trimming of the elements of the chips and, accordingly, it can reduce the cost remarkably by mass production.

In the existing technique for producing semiconductor devices, however, it was difficult to make monolithic microwave integrated circuits of equal characteristics in a high reproducibility and, therefore, a selection step to select usable chips was indispensable. Further, since the monolithic microwave integrated circuits handle high frequency signals, it is difficult to determine their performance when they form part of a wafer by methods such as connecting probes to them.

WO 82/02603 describes a technique for determining the DC characteristics of a connecting grid of conductors which are formed on a substrate by connecting probes to them to ensure the continuity of the connecting grid before individual preselected integrated circuit chips are attached to the substrate carrying the connecting grid.

Accordingly, with monolithic microwave integrated construction it was the practice to divide the chip into separate dice, assembly the separate dice into a monolithic microwave integrated circuit and then test them by measurement at high frequencies. Since large reductions in cost and time can be expected by simplifying this selection process, there is therefore a need for a monolithic microwave integrated circuit which can be selected easily and simply and for a simple method for selecting chips of a monolithic microwave integrated circuit having the required characteristics.

According to one aspect of this invention a monolithic microwave integrated construction including a substrate, a plurality of separate and distinct circuits, similar to each other, integrated onto said substrate, each such circuit having at least two stages that are resistance-capacitance coupled to one another and bonding pads that are indispensable for normal operation of the circuit at microwave frequencies for connecting input and output signals and power supplies to the circuit,

is characterised in that it also includes additional contact pads to enable the direct current characteristics of said circuit to be measured, the additional contact pads being provided by opening up contact windows to enable contact to be established with electrically conducting portions of electrodes of capacitors, so that the area of electrical conductors present is not increased substantially by them.

According to another aspect of this invention, a method for manufacturing microwave integrated circuits comprising integrating a plurality of separate and distinct circuits, similar to one another, onto a single substrate, each such circuit having at least two stages that are resistance-capacitance coupled together and bonding pads that are indispensable for normal operation of the circuit at microwave frequencies for connecting input and output signals and power supplies to the circuit,

is characterised in that the each circuit further includes additional contact pads formed by opening up contact windows to enable contact to be established with electrically conducting portions of electrodes of capacitors, so that the area of the electrical conductors present is not increased substantially by them, and in that the method includes a measuring and selection step in which the direct current characteristics of each of the circuits are measured by probing said additional contact pads to measure circuit characteristics of said separate and distinct circuits whilst connected to the same substrate, and selecting circuit chips for further manufacturing steps based on the results of the measurements obtained by probing.

A particular example of a circuit and method in accordance with this invention will now be described with reference to the accompanying drawings, in which:-

Figure 1 is a circuit diagram; and,

Figure 2 is a mask pattern of the circuit.

The present invention is not limited at all in material. The present invention is applicable to a wide range of general transistor materials such as elemental transistors and compound transistors. In the following description, however, the present invention will be explained with reference to GaAs which is one of compound transistors having an advantage of high operation speed as the transistor material.

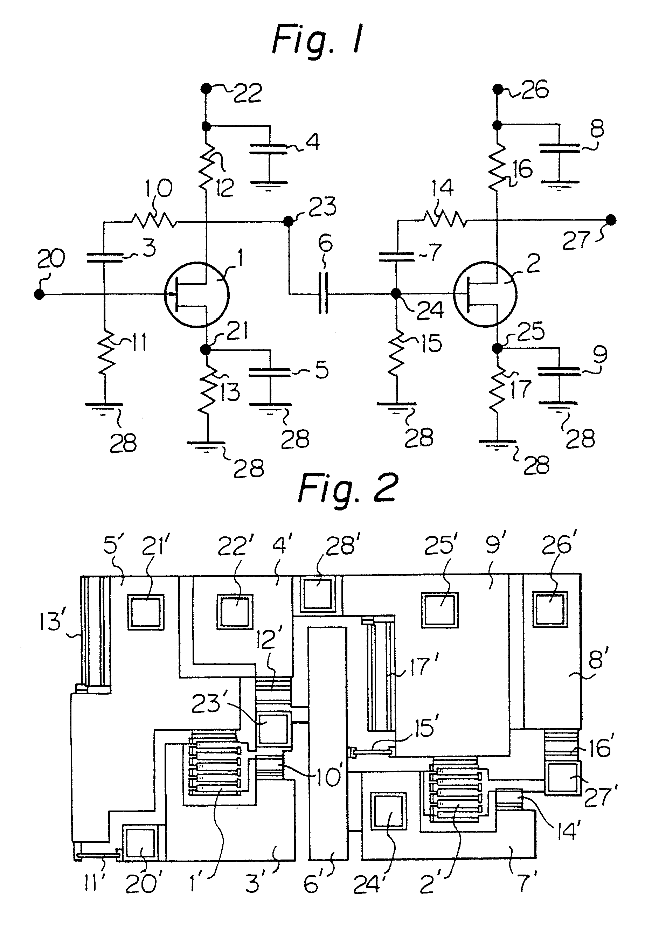

Fig. 1 shows a circuit diagram of an embodiment of a monolithic microwave integrated circuit according to the present invention, in which reference numerals 1 and 2 denote MESFET's, 3 to 9 denote capacitances, and 10 to 17 denotes resistances. The interstage coupling in this circuit is the resistance-capacitance coupling.

The method for selection according to the present invention is characterized in that the layout pattern of a monolithic microwave integrated circuit is added with structurally indispensable pads or pads for measurement and selection of direct current characteristics.

Fig. 2 shows an example of the mask pattern of the monolithic microwave integrated circuit according to the present invention, in which reference numerals 1' and 2' denote MESFET's, 3'to 9' denote capacitances, and 10' to 17' denote resistances, corresponding respectively to component elements of Fig. 1. Reference numerals 20', 22', 26', 27' and 28' denote structurally indispensable bonding pads, and 21', 23', 24' and 25' denote direct current characteristics measuring and selecting pads. Since the monolithic microwave integrated circuit is of the resistance-capacitance coupling circuit construction, the direct current characteristics of MESFET can be measured by combination of these pads. For measuring MESFET 1' and 2', the pads 20', 21', 23' and 24', 25', 27' are used. The pads 20' to 28' correspond to contact points of the corresponding number in the circuit shown in Fig. 1.

Generally, variation in the characteristics of monolithic microwave integrated circuits are dependent greatly upon variation in the characteristics of active elements MESFET. Efficient selection taking notice to the fact mentioned above is made possible by measuring the direct current characteristics of MESFET using the added pads for measuring and selecting the direct current characteristics. The high frequency characteristics of the monolithic microwave integrated circuit, such as the gain of an amplifier circuit, can be easily estimated from the direct current characteristics of MESFET. Further, since the measurement described above does not use high frequency signals, it can be performed by probing or like method in the state of wafers without the need for division and final assembly of chips previously. This can realize a sharp reduction of producing steps and materials.

Addition of the pads 21', 24' and 25' does not cause any deterioration of the high frequency characteristics because the newly added pads use effectively the metal surface on the upper side of the capacitor and the pad 23' is small in area.

As described hereinabove, the monolithic microwave integrated circuit according to the present invention has a great industrial value in that selection of the circuits after production is made very easily without sacrificing the high frequency characteristics by adding the pads for measuring and selecting the direct current characteristics. Further, in the method according to the present invention, since the monolithic microwave integrated circuit is probed in the state of a wafer, it is made possible to select the circuits very easily, and to discriminate the quality of the chips before measurement of their high frequency characteristics after assembly steps (dicing, packaging), to thereby realize reduction in time and cost for production.

While the present invention has been described with reference to a specific example of circuit, it is to be distinctly understood that the present invention is not limited thereto but may be otherwise variously applied to monolithic microwave integrated circuits of resistance-capacitance coupling construction.

## Claims

1. A monolithic microwave integrated construction including a substrate, a plurality of separate and distinct circuits, similar to each other, integrated onto said substrate, each such circuit having at least two stages that are resistance-capacitance coupled to one another and bonding pads (20, 22, 26, 27 and 28) that are indispensable for normal operation of the circuit at microwave frequencies for connecting input and output signals and power supplies to the circuit,

   characterised in that it also includes additional contact pads (21, 23, 24 and 25) to enable the direct current characteristics of said circuit to be measured, the additional contact pads (21,23,24 and 25) being provided by opening up contact windows to enable contact to be established with electrically conducting portions of electrodes of capacitors (5, 6, 7 and 9), so that the area of electrical conductors present is not increased substantially by them.

2. A method for manufacturing microwave integrated circuits comprising integrating a plurality of separate and distinct circuits, similar to one another, onto a single substrate, each such circuit having at least two stages that are resistance-capacitance coupled together and bonding pads (20, 22, 26, 27 and 28) that are indispensable for normal operation of the circuit at microwave frequencies for connecting input and output signals and power supplies to the circuit,

   characterised in that the each circuit further includes additional contact pads (21, 23, 24 and 25) formed by opening up contact windows to enable contact to be established with electrically conducting portions of electrodes of capacitors (5, 6, 7 and 9), so that the area of the electrical conductors present is not increased substantially by them, and in that the method includes a measuring and selection step in which the direct current characteristics of each of the circuits are measured by probing said additional contact pads (21, 23, 24 and 25) to measure circuit characteristics of said separate and distinct circuits whilst connected to the same substrate, and selecting circuit chips for further manufacturing steps based on the results of the measurements obtained by probing.

## Revendications

1. Construction intégrée monolithique à micro-ondes comprenant un substrat, un certain nombre de circuits séparés et distincts, similaires les uns aux autres, intégrés sur ledit substrat, chaque circuit ayant au moins deux étages qui sont couplés l'un à l'autre par résistance-capacitance et des plots de liaison (20, 22, 26, 27 et 28) qui sont indispensables pour un fonctionnement normal du circuit aux fréquences des micro-ondes pour connecter les signaux d'entrée et de sortie et les alimentations en énergie au circuit,

caractérisée en ce qu'elle comprend également des plots additionnels de contact (21, 23, 24 et 25) pour permettre de mesurer les caractéristiques en courant continu dudit circuit, les plots additionnels de contact (21, 23, 24 et 25) étant formés en ouvrant des fenêtres de contact pour permettre d'établir le contact avec des portions électriquement conductrices des électrodes des condensateurs (5, 7 et 9) de manière que l'aire des conducteurs électriques présents ne soit pas sensiblement accrue par eux.

2. Procédé de fabrication de circuits intégrés à micro-ondes comprenant l'intégration d'un certain de nombre de circuits séparés et distincts, similaires les uns aux autres, sur un seul substrat, chaque circuit ayant au moins deux étages qui sont couplés l'un à l'autre par résistance-capacitance et des plots de liaison (20, 22, 26, 27 et 28) qui sont indispensables pour un fonctionnement normal du circuit aux fréquences des micro-ondes pour connecter les signaux d'entrée et de sortie et des alimentations en énergie au circuit,

caractérisé en ce que chaque circuit contient de plus des plots additionnels de contact (21, 23, 24 et 25) formés en ouvrant des fenêtres de contact pour permettre d'établir le contact avec des portions électriquement conductrices des électrodes des condensateurs (5, 6, 7 et 9) de manière que l'aire des conducteurs électriques présents ne soit pas sensiblement accrue par eux et en ce que le procédé comprend une étape de mesure et de sélection par laquelle les caractéristiques en courant continu de chacun des circuits sont mesurées, en sondant lesdits plots additionnels de contact (21, 23, 24 et 25) pour mesurer les caractéristiques de circuit desdits circuits séparés et distincts tandis qu'ils sont connectés au même substrat et en sélectionnant des puces de circuit pour d'autres étapes de fabrication en se basant sur les résultats des mesures obtenues en sondant.

## Ansprüche

1. Monolithische integrierte Mikrowellenschaltung mit einem Substrat, mehreren gleichen oder ähnlichen, getrennten, einzelnen Schaltungen, die auf diesem Substrat integriert sind, wobei jede dieser Schaltungen mindestens zwei RC-gekoppelte Stufen aufweist sowie Anschlußflächen (20, 22, 26, 27, 28), die für den normalen Betrieb der Schaltung bei Mikrowellen-Frequenzen zum Anschluß des Signalein- und -ausgangs und zur Stromversorgung der Schaltung unbedingt erforderlich sind,

dadurch gekennzeichnet, daß weitere Anschlußflächen (21, 23, 24, 25) enthalten sind, die die Messung der Gleichstromcharakteristiken der Schaltung erlauben, wobei die zusätzlichen Anschlußflächen (21, 23, 24, 25) durch das Öffnen von Kontaktfenstern zur Verfügung gestellt werden, die es erlauben, mit elektrisch leitenden Bereichen der Elektroden von Kondensatoren (5, 6, 7, 9) Kontakt herzustellen, ohne daß die Fläche der vorhandenen elektrischen Leiter dadurch wesentlich vergrößert ist.

2. Verfahren zur Herstellung von integrierten Mikrowellenschaltungen, bei dem mehrere gleiche oder ähnliche, getrennte, einzelne Schaltungen auf einem einzelnen Substrat integriert werden, wobei jede dieser Schaltungen mindestens zwei RC-gekoppelte Stufen aufweist sowie Anschlußflächen (20, 22, 26, 27, 28), die für den normalen Betrieb der Schaltung bei Mikrowellen-Frequenzen zum Anschluß des Signalein- und - ausgangs und zur Stromversorgung der Schaltung unbedingt erforderlich sind,

dadurch gekennzeichnet, daß jede Schaltung weiter zusätzliche, durch Öffnen von Kontaktfenstern bildbare Anschlußflächen (21, 23, 24, 25) enthält, die es ermöglichen, mit elektrisch leitenden Bereichen von Elektroden von Kondensatoren (5, 6, 7, 9) Kontakt herzustellen, wobei die Fläche der vorhandenen elektrischen Leiter dadurch nicht we sentlich vergrößert ist, und daß das Verfahren weiter einen Meß- und Auswählschritt enthält, bei dem die Gleichstromcharakteristiken jeder Schaltung gemessen werden, indem an den zusätzlichen Kontaktflächen (21, 23, 24, 25) mit Meßfühlern die Charakteristiken der einzelnen, getrennten Schaltungen gemessen werden, während sie mit demselben Substrat verbunden sind, und die Schaltungs-Chips für weitere Fertigungsschritte anhand der mit den Meßfühlern erhaltenen Meßergebnisse ausgewählt werden.

# Fig. 1

# Fig. 2